# EUROPÄISCHE PATENTSCHRIFT

(11) **EP 2 084 102 B1**
(45) Veröffentlichungstag und Bekanntmachung des Hinweises auf die Patenterteilung: **26.10.2011**
(21) Anmeldenummer: 07802761.2
(22) Anmeldetag: 21.08.2007
(51) Int. Cl.: B81C 1/00

(54) **VERFAHREN ZUR HERSTELLUNG EINES MIKROMECHANISCHEN BAUELEMENTES MIT EINER DÜNNSCHICHT-VERKAPPUNG**
METHOD FOR PRODUCING A MICROMECHANICAL COMPONENT WITH THIN-FILM CAPPING
PROCÉDÉ DE CONSTRUCTION D'UN COMPOSANT MICROMÉCANIQUE DOTÉ D'UN RECROUVEMENT EN COUCHE MINCE

(30) Priorität: 19.10.2006 DE 102006049259
(43) Veröffentlichungstag der Anmeldung: 05.08.2009
(73) Patentinhaber: Robert Bosch GmbH, 70442 Stuttgart (DE)
(72) Erfinder: KRONMUELLER, Silvia, 71409 Schwaikheim (DE); FEYH, Ando, 71732 Tamm (DE); FUCHS, Tino, 72076 Tuebingen (DE); LEINENBACH, Christina, 66806 Ensdorf (DE); LAMMER, Marco, 70199 Stuttgart (DE)
(86) Internationale Anmeldenummer: PCT/EP2007/058684
(87) Internationale Veröffentlichungsnummer: WO 2008/046682

(56) Entgegenhaltungen:
- WO-A-2006/081636
- US-A1- 2004 245 586
- US-A1- 2004 248 344

## Beschreibung

### Stand der Technik

Die Erfindung betrifft ein Verfahren zur Herstellung eines mikromechanischen Bauelementes mit einer Kappenschicht aus Silizium.

Die Verkappung empfindlicher mikromechanischer Sensorelemente erfolgt konventionell durch Aufbonden/Aufkleben eines Kappenwafers auf den vollständig prozessierten Sensorwafer. Zum Einschluss einer definierten Atmosphäre bzw. eines definierten Druckes muss dieser Prozessschritt unter den selben Bedingungen erfolgen. Der Kappenwafer wird vorstrukturiert, üblicherweise mit KOH-Ätzen, um die Beweglichkeit der Sensorstrukturen sicherzustellen. Eines der Probleme bei diesem aufwändigen Verfahren besteht darin, dass die Sensorstrukturen bei Aufbringen der Verkappung frei beweglich und daher extrem empfindlich gegen Stöße und Partikelverunreinigungen sind.

Eine seit neuerem bekannte Verkappungstechnologie, die Dünnschicht-Verkappung, verzichtet auf einen Kappenwafer und bildet stattdessen einen Hohlraum zwischen den freizulegenden mikromechanischen Strukturen und einer mit einem üblichen Depositionsprozess erzeugten Siliziumschicht (Kappenschicht) aus. Diese Methode beruht darauf, eine unterhalb einer bereits bestehenden Silizium(Si)-Kappenschicht liegende Füllschicht durch Ätzen zu entfernen, um so den Hohlraum zu schaffen. Zum Heranführen des Ätzgases an die Füllschicht wird üblicherweise eine Perforation der Kappenschicht erzeugt, die später - nach Wegätzen der Füllschicht und ggf. weiterer Opferschichten - durch Abscheiden einer Verschlussschicht wieder versiegelt wird. Wenn Ätzgas durch die Si-Kappenschicht geleitet werden soll, sind jedoch mehr oder weniger aufwändige Maßnahmen nötig, damit das Ätzgas nicht auch die Si-Kappenschicht angreift.

In diesem Zusammenhang ist aus der DE 100 06 035 A1 eine Dünnschichtverkappung (Füllpoly-Technologie) bekannt, bei der die Si-Kappenschicht mit einer Perforation aus Trenches versehen wird, die durch ein konventionelles Tiefenätzverfahren hergestellt werden. Um die Füll-Epipoly-Si-Schicht mit dem Ätzgas ClF₃ selektiv in Bezug auf die Si-Kappenschicht ätzen zu können, werden eine Seitenwandpassivierung der Trenches sowie weitere Schutzschichten vorgeschlagen.

Die DE 10 2004 036 803 A1 offenbart ein zur Dünnschichtverkappung einsetzbares Ätzverfahren, bei dem mit ClF₃ als Ätzmedium in Kombination mit einer zu entfernenden (Füll)schicht aus Silizium-Germanium (Si₁₋ₓGeₓ₎-Legierung eine sehr hohe, erwünschte Selektivität gegenüber Polysilizium von etwa 4000:1 erreichbar ist. Im Zusammenhang mit der Herstellung einer PolySi-Kappenschicht ist diese Selektivität ausreichend, um das Ätzgas - ohne Angriff der Kappe - durch konventionell mittels Maskentechnik in der Kappenschicht erzeugte Trenches zu leiten. Um diese relativ großen (Mikrometerbereich) Trenches bzw. Öffnungen in der Kappe versiegeln zu können, ist jedoch, wie in der genannten Offenlegungsschrift erwähnt, eine Verschlussschicht mit einer relativ großen Dicke von etwa 1 bis 20 µm erforderlich. Bei derart dicken Verschlussschichten besteht jedoch immer die Gefahr, dass die unter den großen Öffnungen freiliegenden mikromechanischen Strukturen unerwünschterweise mitbeschichtet werden. Andererseits ist zu bedenken, dass die bei dem bekannten Verfahren zur Verfügung stehende Selektivität nicht hoch genug ist, um bei porosifiziertem Kappensilizium, dessen Öffnungen im Nanometerbereich liegen, einen Angriff des Ätzgases auf das in Form kleiner Körnchen vorliegende poröse Si-Material zu verhindern.

Aus der DE 199 61 578 A1 ist ein Verfahren bekannt, bei dem die Si-Kappe mit Mikroporen versehen wird. Dabei wird als konventionelle Füll- bzw. Opferschicht ein Oxid auf Siliziumbasis verwendet, das mittels HF-Dampfätzen - einem gegenüber dem Kappensilizium ausreichend selektiven, aber relativ langsamen Prozess - weggeätzt wird.

Das Dokument US 2004/248344 A1 offenbart ein Verfahren zur Herstellung eines mikromechanischen Bauelements mit einer Kappenschicht aus Silizium, wobei die Kappenschicht über eine Silizium-Germanium-Füllschicht abgeschieden wird. Die Kappenschicht wird anschließend porös gemacht, und die Silizium-Germanium-Füllschicht darunter durch Gasphasen-Ätzen entfernt.

### Offenbarung der Erfindung

Der Erfindung liegt daher die Aufgabe zugrunde, eine verbesserte Dünnschicht-Verkappungstechnologie bereitzustellen. Diese Aufgabe wird erfindungsgemäß durch ein Verfahren gemäß Anspruch 1 gelöst. Weiterbildungen und bevorzugte Maßnahmen ergeben sich aus den Unteransprüchen.

Bei der erfindungsgemäßen Lösung wird das genannte Ziel erreicht durch Abscheiden einer SiGe-Füllschicht auf einem Substrat und Ausbilden einer Germanium(Ge)-reichen-Schicht, wobei diese entweder durch einen nach oben zunehmenden Germanium-Konzentrationsgradienten der SiGe-Füllschicht selbst, oder durch Abscheiden einer zusätzlichen Germanium(Ge)-Schicht auf die SiGe-Füllschicht gebildet wird, durch anschließendes Abscheiden einer Si-Kappenschicht auf die Ge-reiche-Schicht, darauf folgende Erzeugung von Mikroporen in der Si-Kappenschicht und in der Ge-reichen-Schicht, deren Durchmesser im Nanometerbereich liegen, wodurch poröse Schichten erzeugt werden, weiter durch thermisches Oxidieren der porösen Schichten und anschließendes Entfernen des Oxids der porösen Ge-reichen-Schicht mittels eines Oxidlöse-Prozesses, sowie durch Entfernen der SiGe-Füllschicht und der Ge-reichen-Schicht durch Gasphasenätzen mit durch die Mikroporen herangeführtem ClF₃. Abschließend erfolgt noch ein Versiegeln der Mikroporen durch Abscheiden einer Verschlussschicht auf die poröse Si-Kappenschicht.

Die Grundidee ist die Bereitstellung einer Dünnschicht-Verkappungstechnologie, bei der trotz Freilegung der mit einer SiGe-(Opfer)Füllschicht umgebenen Sensorstrukturen mittels ClF₃-Ätzen durch kleine Poren in der Si-Verkappung hindurch und den mit dieser Prozessführung verbundenen Vorteilen ein Ätzangriff auf die Si-Kappe auf prozesstechnisch wenig aufwändige Weise verhindert wird, nämlich entweder durch besonders selektive (etwa 10000:1 oder höher) Einstellung des Ätzprozesses selbst oder dadurch, die Einsicht, dass das Oxid einer Ge-Schicht im Gegensatz zum oxidierten porösen Si nicht stabil, sondern leicht lösbar ist, in der angegebenen Weise in den erfindungsgemäßen Zusammenhang zu stellen.

Durch das erfindungsgemäße Verfahren lassen sich die allgemeinen Vorteile der Dünnschicht-Technologie realisieren. Das heißt, es sind keine Bondprozesse und keine Kappenwafer erforderlich. Die Verkappung ist direkt auf den Sensorstrukturen integriert. Durch die geringe Höhe von max. einigen 10 µm wird das Volumen des Sensorelements reduziert.

Gemäß einer Ausführungsform der zweiten erfindungsgemäßen Lösung ist es von Vorteil, dass die Ge-reiche-schicht eine Dicke von nur etwa 30 bis 100 nm aufweist. Außerdem kann die thermische Oxidierung vorteilhaft bei Temperaturen von etwa 200 bis 400 Grad Celsius erfolgen, so dass keine thermische Beeinträchtigung der SiGe bzw. Ge-reichen-Schicht stattfindet. Von besonderem Vorteil bei allen Varianten der zweiten erfindungsgemäßen Lösung ist die Möglichkeit, das Oxid der Ge-reichen-Schicht einfach in Wasser oder Wasserdampf aufzulösen.

Als besonders vorteilhaft wird eine Ausführungsform der Erfindung angesehen, bei der vor Abscheidung der SiGe- Füllschicht unter den freizulegenden mikromechanischen Strukturen eine SiGe-Opferschicht aufgebracht wird, und bei der die Si-Ge-Opfer- und Füllschichten in einem Schritt weggeätzt und die Strukturen freigelegt werden.

Alternativ dazu besteht bei allen Varianten der beiden erfindungsgemäßen Lösungen die Möglichkeit, dass die Abscheidung der SiGe-Füllschicht auf mikromechanische Strukturen erfolgt, die bereits mit Hilfe einer nicht aus SiGe bestehenden Opferschicht freigelegt wurden.

Bei allen Varianten der Erfindung besteht eine besonders vorteilhafte Weiterbildung darin, dass der Durchmesser der Mikroporen im Bereich von 2-20 nm liegt. Dadurch kann die Verschlussschicht eine sehr geringe Dicke um 100 nm aufweisen, so dass die freigelegten Sensorstrukturen bei der Versiegelung der Kappe nicht mehr in Mitleidenschaft gezogen werden.

Derart feine Mikroporen können im Übrigen auf einfache Weise durch elektrochemisches Ätzen oder durch einen stromlosen Stain-Etch-Prozess erzeugt werden.

### Kurze Beschreibung der Zeichnungen

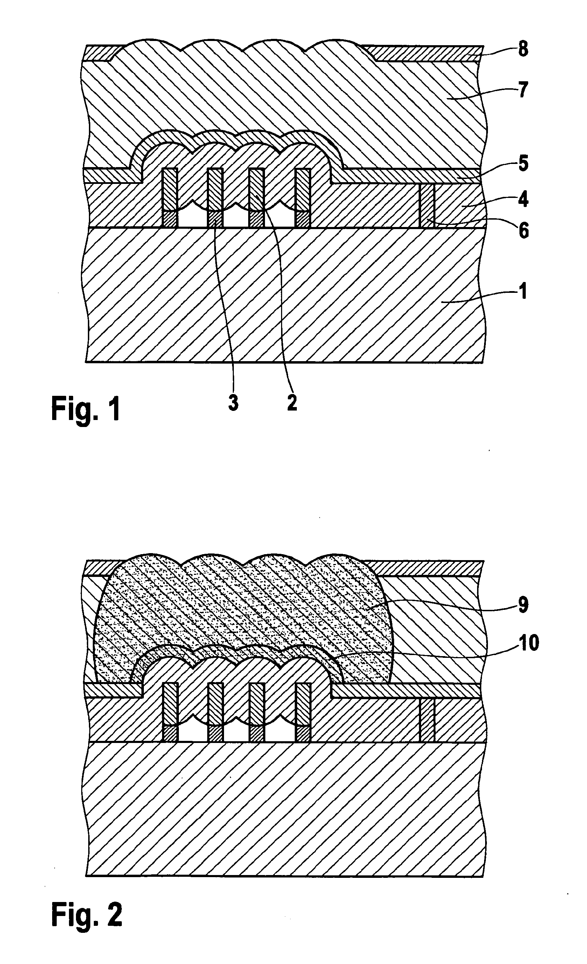

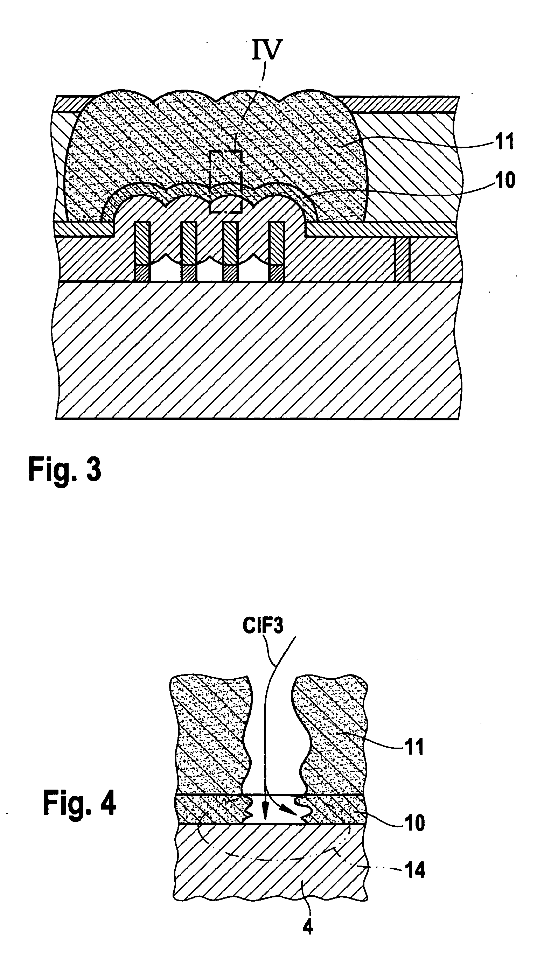

Figur 1 bis 5 zeigen, jeweils im Schnitt, das erfindungsgemäße Herstellungsverfahren in einem Ausführungsbeispiel, wobei Figur 4 ein vergrößertes Detail aus der Figur 3 darstellt.

### Ausführungsform der Erfindung

In Figur 1 ist ein Herstellungsstadium dargestellt, in dem bereits mikromechanische Strukturen 2, beispielsweise eine Kammstruktur für einen Drehraten- oder Beschleunigungssensor, auf einem Siliziumsubstrat 1 strukturiert, aber noch nicht durch Ätzen einer unterhalb der Strukturen 2 befindlichen Opferschicht 3 - vorzugsweise auf SiGe-Opferschicht-Basis - freigelegt worden sind. Es sind jedoch auch Abwandlungen mit z.B. Poly-Si-Opferschichten 3 vorstellbar, bei denen die Strukturen 2 vor den im Folgenden beschriebenen Verfahrensschritten freizulegen sind.

In jedem Fall werden die Sensorstrukturen 2 anschließend mit einer Silizium-Germanium (SiGe) Füllschicht 4 abgedeckt. Sie sind somit bis zum Ätzen der SiGe-Opferschicht 3 ortsfest und daher unempfindlich gegenüber mechanischen Stößen. Die SiGe-Füllschicht 4 wird später mittels ClF₃-Ätzen hochselektiv gegenüber den Silizium-Sensorstrukturen 2 entfernt und ist insofern auch eine Opferschicht. Auf die SiGe-Füllschicht 4 wird die in Figur 1 erkennbare (einige 100nm bis einige Mikrometer dicke) Poly-Si Schicht 7 abgeschieden. Diese wird anschließend, wie bei den weiteren Verfahrensschritten gemäß Figur 2 bis 5 noch näher beschrieben, porosifiziert und dient später als Dünnschichtkappe 7. Zunächst jedoch wird das SiGe der Füllschicht 4 vorzugsweise p-dotiert. Hierauf erfolgt die Abscheidung einer dünnen Germanium Schicht 5 mit einer Dicke von einigen 10-100nm, ebenfalls p-dotiert, vgl. Figur 1. Alternativ, statt zusätzlicher Ge-Schicht 5, kann lediglich die SiGe-Füllschicht 4 mit einem Ge-Konzentrationsgradienten abgeschieden werden, so dass in ihrem oberem, substratfernen Bereich eine Ge-reiche-(Teil)schicht 5 resultiert.

Gegebenenfalls ist die Bereitstellung eines elektrischen Kontakts 6 zum Substrat 1 für die spätere Porenbildung erforderlich, vgl. Figur 1. Dieser Anschluss kann auch über die SiGe-Schicht 4 oder die Poly-Si-Schicht 7 erfolgen. Auf der Ge-reichen-Schicht 5 erfolgt die Abscheidung der bereits erwähnten dicken poly-Si Schicht 7, p-dotiert. Diese stellt die spätere Kappe 7 dar.

Die Poly-Si Schicht 7 und die Ge-reiche-Schicht 5 werden mittels elektrochemischem Ätzen in Flusssäure (HF) bereichsweise porosifiziert, so dass der in Figur 2 dargestellte Zustand mit den porösen Schichten 9 und 10 resultiert. Hierzu wird zuvor eine Ätzmaske 8, vgl. Figur 1, abgeschieden und strukturiert. Vorzugsweise finden hierbei Schichten 8 aus SiN, Si₃N₄ oder n-Dotierungen Anwendung.

Alternativ zum elektrochemischen Ätzen kann auch ein an sich bekannter stromloser Ätzprozess (sog. Stain-Etch) verwendet werden. Hier erfolgt die Mikroporenbildung in einem Gemisch aus HF und einem Oxidationsmittel (z.B. H₂0₂, HN0₃). Bei diesem stromlosen Verfahren kann der elektrische Kontakt 6 zum Substrat 1 entfallen.

Nachfolgend werden die in Figur 2 erkennbaren porösen Schichten 9 und 10 thermisch oxidiert, so dass der Zustand gemäß Fig.3 resultiert. Diese Oxidation erfolgt vorzugsweise bei geringen Temperaturen um 200-400°C, so dass keine thermische Beeinflussung der SiGe-Füllschicht 4 bzw. der Ge-reichen-Schicht 5 stattfindet. Das Oxid der Ge-reichen-Schicht 5 ist im Gegensatz zum oxidierten porösen Silizium 11 nicht stabil und kann z.B. in H₂0 oder H₂O-Dampf gelöst werden. Das oxidierte poröse Silizium 11 stellt nun Zugangslöcher für den C1F₃-Ätzprozess dar. Nach unten wird der Zugang durch die poröse Ge-reiche-Schicht 10 sichergestellt, deren Oxidfilm, wie beschrieben, entfernt wurde. Da Oxid im C1F₃-Ätzprozess inert ist, wird der poröse Silizium-Bereich 11 (spätere Kappe 7) nicht angegriffen. Die poröse Ge-reiche-Schicht 10 dagegen wird in ClF₃ rasch entfernt. Anschließend werden die SiGe-Füllschicht 4 und die SiGe-Opferschicht 3 in einem Schritt mit C1F₃ geätzt. Diese Verfahrensschritte sind in Fig. 4 in einem vergrößerten Ausschnitt verdeutlicht, wobei die Region 14 des Ätzangriffes angedeutet ist.

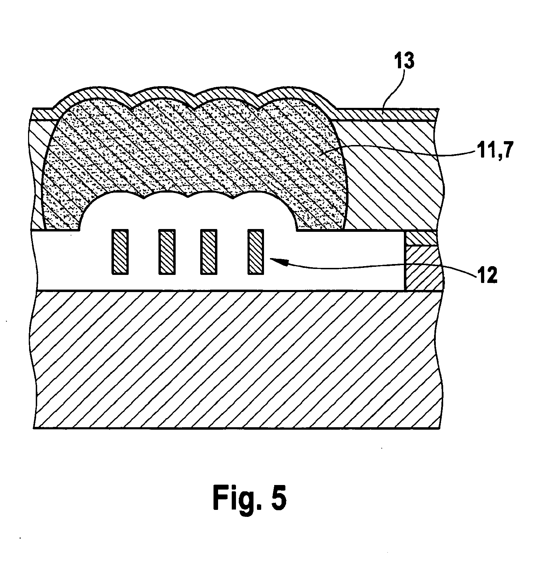

Wie in Figur 5 zu erkennen ist, werden durch die C1F₃-Ätzung freigelegte Sensorstrukturen 12 erzeugt. Bei Verwendung eines SiGe-Opferschicht-MEMS Prozesses wird die Füllschicht 4 und die Opferschicht 3 in einem Schritt entfernt. Es ist jedoch, wie bereits erwähnt, auch vorstellbar, MEMS-Prozesse ohne Si-Ge-Opferschicht 3 mit diesem Verfahren zu verkappen: In diesem Falle werden die bereits vorab freigelegten Sensorstrukturen 12 mit der SiGe-Füllschicht 4 abgedeckt. Der weitere Verlauf stimmt mit dem oben beschriebenen überein.

Durch geeignete Wahl der ClF₃-Ätzparameter und der SiGe-Zusammensetzung, also des jeweiligen Si- bzw. Ge-Anteils, kann auch ohne Einsatz einer Ge-reichen-Schicht 5 eine entsprechend hohe Selektivität zwischen der SiGe-Füllschichtund der Ätzung des porosifizierten Si in C1F₃ eingestellt werden, so dass auf eine Oxidation sogar vollständig verzichtet werden kann. Dies vereinfacht den Prozess erheblich, da auch der Oxidlöse-Prozess entfällt.

Abschließend, vgl. Figur 5, wird die poröse Kappe 7 bzw. 11 mittels Abscheidung einer dünnen Verschlussschicht 13 versiegelt. Die Öffnungen, das heißt Mikroporen dieser Kappe 7, liegen im Bereich von 2-20, insbesondere weniger als 5 nm Durchmesser und können daher mit für einen zuverlässigen Verschluss ausreichend Verschlussschichten 13 mit einer Dicke um 100nm verschlossen werden, ohne dass die darunterliegende Sensorstruktur 12 mitbeschichtet wird. Bei dem Verschluss kann, je nach Depositionsverfahren, ein Prozessvakuum oder eine definierte Prozessatmosphäre eingeschlossen werden.

Außerdem kann vor der Verkappung eine ASC (Anti-Stiction-Coating) Schicht durch das poröse Silizium 7, 11 auf den freigelegten MEMS-Strukturen 12 abgeschieden werden. Das erfindungsgemäße Verfahren ist bei sämtlichen Sensoren auf Siliziumbasis, welche eine Verkappung benötigen, anwendbar.

## Patentansprüche

1. Verfahren zur Herstellung eines mikromechanischen Bauelementes mit einer Kappenschicht aus Silizium, mit mindestens folgenden Schritten:
- Abscheiden einer Silizium-Germanium-Füllschicht (4) auf einem Substrat (1) und Ausbilden einer Germanium-reichen-Schicht (5), wobei diese entweder durch einen nach oben zunehmenden Germanium-Konzentrationsgradienten der Silizium-Germanium-Füllschicht (4), oder durch Abscheiden einer zusätzlichen Germanium-Schicht (5) auf die Silizium-Germanium-Füllschicht (4) gebildet wird,
- Abscheiden einer Silizium-Kappenschicht (7) auf die Germanium-reiche-Schicht (5),
- Erzeugung von Mikroporen in der Silizium-Kappenschicht (7) und in der Germanium-reichen-Schicht (5), deren Durchmesser im Nanometerbereich liegen, wodurch poröse Schichten (9, 10) erzeugt werden,
- Thermisches Oxidieren der porösen Schichten (9, 10) und anschließendes Entfernen des Oxids der porösen Germanium-reichen-Schicht (10) durch einen Oxidlöse-Prozess,
- Entfernen der Silizium-Germanium-Füllschicht (4) und der Germanium-reichen-Schicht (5, 10) durch Gasphasenätzen mit durch die Mikroporen herangeführtem ClF₃,
- Versiegeln der Mikroporen durch Abscheiden einer Verschlussschicht (13) auf die poröse Silizium-Kappenschicht (11).

2. Verfahren nach Anspruch 1, **dadurch gekennzeichnet, dass** die Germanium-reiche-Schicht (5, 10) eine Dicke von etwa 30 bis 100 nm aufweist.

3. Verfahren nach Anspruch 1 oder 2, **dadurch gekennzeichnet, dass** die thermische Oxidierung bei Temperaturen von etwa 200 bis 400 Grad Celsius erfolgt.

4. Verfahren nach einem der Ansprüche 1 bis 3, **dadurch gekennzeichnet, dass** das Oxid der Germanium-reichen-Schicht (10) in Wasser oder Wasserdampf gelöst wird.

5. Verfahren nach einem der Ansprüche 1 bis 4, **dadurch gekennzeichnet, dass** vor Abscheidung der Silizium-Germanium-Füllschicht (4) unter den freizulegenden mikromechanischen Strukturen (2) eine Silizium-Germanium-Opferschicht (3) aufgebracht wird, und dass die Silizium-Germanium-Opfer- und Füllschichten (3, 4) in einem Schritt weggeätzt und die Strukturen (2, 12) freigelegt werden.

6. Verfahren nach einem der Ansprüche 1 bis 4, **dadurch gekennzeichnet, dass** die Abscheidung der Silizium-Germanium-Füllschicht (4) auf bereits mit Hilfe einer nicht aus Silizium-Germanium bestehenden Opferschicht freigelegte mikromechanische Strukturen (12) erfolgt.

7. Verfahren nach einem der Ansprüche 1 bis 6, **dadurch gekennzeichnet, dass** der Durchmesser der Mikroporen im Bereich von 2-20 nm liegt.

8. Verfahren nach Anspruch 7, **dadurch gekennzeichnet, dass** die Verschlussschicht (13) eine Dicke um 100 nm aufweist.

9. Verfahren nach einem der Ansprüche 1 bis 8, **dadurch gekennzeichnet, dass** die Mikroporen durch elektrochemisches Ätzen oder durch einen stromlosen Stain-Etch-Prozess erzeugt werden.

## Claims

1. Method for producing a micromechanical component having a cap layer of silicon, said method comprising at least the following steps:
- a silicon-germanium filling layer (4) is deposited on a substrate (1) and a germanium-rich layer (5) is formed, the latter being formed either by an upwardly increasing germanium concentration gradient of the silicon-germanium filling layer (4) or by the deposition of an additional germanium layer (5) on the silicon-germanium filling layer (4),
- a silicon cap layer (7) is deposited on the germanium-rich layer (5),
- micropores having a diameter in the nanometre range are produced in the silicon cap layer (7) and in the germanium-rich layer (5), as a result of which porous layers (9, 10) are produced,
- the porous layers (9, 10) are thermally oxidized and the oxide is subsequently removed from the porous germanium-rich layer (10) by an oxide release process,
- the silicon-germanium filling layer (4) and the germanium-rich layer (5, 10) are removed by vapour phase etching using CIF₃ introduced through the micropores,
- the micropores are sealed by depositing a closure layer (13) on the porous silicon cap layer (11).

2. Method according to Claim 1, **characterized in that** the germanium-rich layer (5, 10) has a thickness of about 30 to 100 nm.

3. Method according to Claim 1 or 2, **characterized in that** the thermal oxidation is effected at temperatures of about 200 to 400°C.

4. Method according to one of Claims 1 to 3, **characterized in that** the oxide from the germanium-rich layer (10) is dissolved in water or water vapour.

5. Method according to one of Claims 1 to 4, **characterized in that** a silicon-germanium sacrificial layer (3) is applied under the micromechanical structures (2) to be exposed before the silicon-germanium filling layer (4) is deposited, and **in that** the silicon-germanium sacrificial and filling layers (3, 4) are etched away in one step and the structures (2, 12) are exposed.

6. Method according to one of Claims 1 to 4, **characterized in that** the silicon-germanium filling layer (4) is deposited on micromechanical structures (12) which have already been exposed with the aid of a sacrificial layer which does not consist of silicon-germanium.

7. Method according to one of Claims 1 to 6, **characterized in that** the diameter of the micropores is in the range of 2-20 nm.

8. Method according to Claim 7, **characterized in that** the closure layer (13) has a thickness of about 100 nm.

9. Method according to one of Claims 1 to 8, **characterized in that** the micropores are produced by electrochemical etching or by a currentless stain-etch process.

## Revendications

1. Procédé de fabrication d'un composant micromécanique avec une couche périphérique en silicium, comportant au moins les étapes suivantes :
- dépôt d'une couche de charge en silicium/germanium (4) sur un substrat (1) et création d'une couche riche en germanium (5), cette dernière étant créée soit par un gradient de concentration de germanium croissant vers le haut de la couche de charge en silicium/germanium (4) ou par dépôt d'une couche de germanium (5) supplémentaire sur la couche de charge en silicium/germanium (4),
- dépôt d'une couche périphérique de silicium (7) sur la couche riche en germanium (5),
- ménagement dans la couche périphérique de silicium (7) et dans la couche riche en germanium (5) de micropores dont les diamètres sont de l'ordre de nanomètres, ce qui a pour effet de créer des couches poreuses (9, 10),
- thermo-oxydation des couches poreuses (9, 10) et ensuite retrait de l'oxyde de la couche poreuse riche en germanium (10) par un processus de dissolution des oxydes,
- retrait de la couche de charge en silicium/germanium (4) et de la couche riche en germanium (5, 10) par décapage en phase gazeuse par CIF₃ amené à travers les micropores,
- scellement des micropores par dépôt d'une couche d'obturation (13) sur la couche périphérique poreuse en silicium (11).

2. Procédé selon la revendication 1, **caractérisé en ce que** la couche riche en germanium (5, 10) présente une épaisseur d'environ 30 à 100 nm.

3. Procédé selon la revendication 1 ou 2, **caractérisé en ce que** la thermo-oxydation s'effectue à des températures d'environ 200 à 400 degrés Celsius.

4. Procédé selon l'une quelconque des revendications 1 à 3, **caractérisé en ce que** l'oxyde de la couche riche en germanium (10) est dissous dans de l'eau ou de la vapeur d'eau.

5. Procédé selon l'une quelconque des revendications 1 à 4, **caractérisé en ce qu**'avant le dépôt de la couche de charge en silicium/germanium (4), on applique sous les structures micromécaniques (2) devant être mises à nu une couche sacrificielle de silicium/germanium (3) et en ce qu'on élimine en une seule étape de décapage la couche sacrificielle de silicium/germanium et la couche de charge (3, 4) et on met à nu les structures (2, 12).

6. Procédé selon l'une quelconque des revendications 1 à 4, **caractérisé en ce que** le dépôt de la couche de charge en silicium/germanium (4) s'effectue sur des structures micromécaniques (12) d'ores et déjà mises à nu à l'aide d'une couche sacrificielle non constituée de silicium/germanium.

7. Procédé selon l'une quelconque des revendications 1 à 6, **caractérisé en ce que** le diamètre des micropores est de l'ordre de 2 à 20 nm.

8. Procédé selon la revendication 7, **caractérisé en ce que** la couche d'obturation (13) présente une épaisseur de 100 nm.

9. Procédé selon l'une quelconque des revendications 1 à 8, **caractérisé en ce qu**'on créé les micropores par décapage électrochimique ou par un processus de dissolution chimique (stain etching) sans courant électrique.
